# EUROPÄISCHE PATENTSCHRIFT

(11) **EP 1 311 909 B1**
(45) Veröffentlichungstag und Bekanntmachung des Hinweises auf die Patenterteilung: **20.10.2010**
(21) Anmeldenummer: 01969594.9
(22) Anmeldetag: 16.08.2001
(51) Int. Cl.: G03F 7/11, B41N 1/06

(54) **VERFAHREN ZUR HERSTELLUNG ORGANISCH ENTWICKELBARER, FOTOPOLYMERISIERBARER FLEXODRUCKELEMENTE AUF FLEXIBLEN METALLISCHEN TRÄGERN**
METHOD FOR PRODUCING ORGANICALLY DEVELOPABLE, PHOTOPOLYMERIZABLE FLEXOGRAPHIC PRINTING ELEMENTS ON FLEXIBLE METALLIC SUPPORTS
PROCEDE POUR PRODUIRE DES ELEMENTS FLEXOGRAPHIQUES A DEVELOPPEMENT ORGANIQUE SUR DES SUPPORTS METALLIQUES SOUPLES

(30) Priorität: 18.08.2000 DE 10040929
(43) Veröffentlichungstag der Anmeldung: 21.05.2003
(73) Patentinhaber: Flint Group Germany GmbH, 70469 Stuttgart (DE)
(72) Erfinder: KNÖLL, Rolf, 69469 Weinheim (DE); TELSER, Thomas, 69469 Weinheim (DE); MENN, Hans, 77731 Willstätt (DE)
(74) Vertreter: Isenbruck, Günter
(86) Internationale Anmeldenummer: PCT/EP2001/009435
(87) Internationale Veröffentlichungsnummer: WO 2002/017020

(56) Entgegenhaltungen:
- EP-A- 0 038 477
- EP-A- 0 053 260
- EP-A- 0 907 110
- EP-A- 0 992 849
- EP-A- 1 136 254
- DE-A- 2 414 596
- DE-A- 2 415 728
- DE-A- 3 015 340

## Beschreibung

Die Erfindung betrifft ein Verfahren zur Herstellung von organisch entwickelbaren, fotopolymerisierbaren Flexodruckelementen auf flexiblen metallischen Trägern. Die Erfindung betrifft weiterhin organisch entwickelbare, fotopolymerisierbare Flexodruckelemente auf flexiblen metallischen Trägern, bei denen die fotopolymerisierbare Schicht mittels einer in Druckfarben und organischen Entwicklern unlöslichen, quellbeständigen, klebfreien Haftschicht auf dem metallischen Träger aufgebracht ist. Die Erfindung betrifft weiterhin organisch entwickelbares, fotopolymerisierbares Flexodruckelement aus einer fotopolymerisierbaren Schicht, die mittels einer in Druckfarben und organischen Entwicklern unlöslichen und quellbeständigen Haftschicht auf einem flexiblen metallischen Träger aufgebracht ist.

Fotopolymerisierbare Flexodruckelemente zur Herstellung von Flexodruckplatten bestehen üblicherweise aus einem flexiblen Schichtträger, einer Haftschicht, einer fotopolymerisierbaren Schicht, einer Entklebungsschicht (oft auch als release-layer bezeichnet) sowie einer Deckfolie zum Schutz der fotopolymerisierbaren Schicht, welche vor dem Belichten abgezogen wird. Als Träger für handelsübliche Flexodruckelemente werden üblicherweise PET-Folien eingesetzt.

Die passergenaue Montage von Flexodruckplatten mit PET-Trägern auf den Druckzylinder erfolgt üblicherweise mittels doppelseitigem Klebeband. In der Regel werden die Flexodruckplatten außerhalb der Druckmaschine auf den ausgebauten Druckzylinder montiert, wobei häufig spezielle Montagegeräte eingesetzt werden. Danach wird der mit den Platten versehene Druckzylinder wieder in die Druckmaschine eingebaut. Sind Korrekturen der Position notwendig, muss der Druckzylinder mit der aufgeklebten Flexodruckplatte wieder aus der Druckmaschine ausgebaut und die aufgeklebte Flexodruckplatte entfernt werden. Dann wird neues doppelseitiges Klebeband auf den Druckzylinder aufgezogen, die Flexodruckplatte erneut aufgeklebt und der Druckzylinder wieder in die Maschine eingebaut. Dieses Verfahren ist jedoch umständlich und zeitaufwändig.

Wässrig entwickelbare, fotopolymerisierbare Hochdruckplatten gemäß dem Stand der Technik werden sowohl auf PET-Träger wie auf metallische Träger aus Aluminium oder Stahl beschichtet. Um eine gute Haftung der fotopolymerisierbaren Schicht auf metallischen Trägern zu gewährleisten, kann beispielsweise eine Kombination von zwei Haftschichten bestehend aus einer Grundierlackschicht und einer Zwischenschicht eingesetzt werden. Als Beispiel sei hier auf DE-A 30 45 516 oder auf EP-A 333 012 verwiesen. Druckplatten auf dünnen metallischen Trägern lassen sich erheblich leichter auf Druckzylinder montieren. Als weitere Erleichterung der passergenauen Montage ist außerdem bekannt, Hochdruckplatten mit einem dünnen Träger aus magnetisierbarem Stahl herzustellen (*Print-it* Nr. 2, Juni 1999, BASF Drucksysteme GmbH, Seite 12-13). Derartige Hochdruckplatten lassen sich passergenau, schnell und einfach auf magnetische Druckzylinder montieren.

Flexodruckplatten auf metallischen Trägern sind prinzipiell bekannt. Flexodruckplatten betreffende Patentanmeldungen bzw. Patente offenbaren häufig in allgemeiner Form in der Beschreibung als mögliche Materialien für den Träger Metalle. Beispielhaft sei hier auf EP-A 992 849 (Abschnitt [0030]) oder auf EP-A 474 178 (Seite 3, Zeilen 50 - 54) verwiesen.

In den Ausführungsbeispielen derartiger Patente bzw. Patentanmeldungen finden sich aber üblicherweise nur Beispiele für Flexodruckelemente auf Trägern aus Polymerfolien, insbesondere PET-Folien. In EP-A 332 983 werden auch Ausführungsbeispiele für Flexodruckplatten auf metallischem Träger offenbart. Bei dem dort offenbarten Flexodruckelement handelt es sich aber nicht um ein organisch entwickelbares Element auf Basis thermoplastisch elastomerer Blockcopolymerer, sondern um ein wässrig entwickelbares Element auf Basis spezieller Polyvinylalkoholderivate als Bindemittel. Derartige Bindemittel sind der Hochdruckplattentechnologie entlehnt, und derartige Flexodruckplatten sind nur mit UV-Farben zum Drucken einsetzbar. Bislang sind keine organisch entwickelbaren Flexodruckplatten auf flexiblem metallischen Träger kommerziell erhältlich.

EP-A 0 038 477 offenbart ein zur Herstellung von Druck- und Reliefformen geeignetes Mehrschichtelement mit (a) einer fotoempfindlichen Schicht aus einer in Wasser oder wässrigem Lösungsmittel löslichen Mischung von mindestens einem hydrohilen polymeren Bindemittel (a1), mindestens einem damit verträglichen fotopolymerisierbaren ethylenisch, ungesättigten Monomer (a2) und einem Fotoinitiator (a3), (b) einer dimensionsstabilen Trägerschicht und (c)einer dünnen Zwischenschicht zwischen Schicht (a) und Schicht (b) enthaltend mindestens 30 Gew.-% eines Umsetzungsproduktes von Polyvinylalkohol mit Acryl- und/oder Methacrylsäureanhydrid mit 3 bis 30 Gew.-%, bezogen auf dieses Umsetzungsprodukt, an seitenständigen Acryloyl und/oder Methacryloylgruppen (c1), und mindestens ein damit verträgliches ethylenisch ungesättigtes Monomer (c2). Die Fotopolymerschicht (a) ist mit Wasser oder mit wässrigen Lösungen entwickelbar. Als hydrophile polymere Bindemittel (a1) der fotoempfindlichen Schicht (a) werden wasserlöslichen Polyvinylalkohole und deren wasserentwickelbare Copolymere und Derivate wie deren Ester, Ether oder Acetale genannt.

DE-A 30 15 340 betrifft ebenfalls ein zur Herstellung von Druck- und Reliefformen geeignetes Mehrschichtelement mit (a) einer fotoempfindlichen Schicht umfassend eine in Wasser oder wässriger Lösung lösliche Mischung von mindestens einem hydrophilen polymeren Bindemittel (a1), mindestens einem damit verträglichen ethylenisch ungesättigten Monomer (a2) und einem Fotoinitiator (a3), (b) einer dimensionsstabilen Trägerschicht und (c) einer dünnen Zwischenschicht umfassend ein mit dem polymeren Bindemittel der Schicht (a) verträgliches polymeres Bindemittel (c1) und ein damit verträgliches ethylenisch ungesättigtes Monomer (c2). Das polymere Bindemittel (c1) der Zwischenschicht (c) ist ein wasserlösliches Vinylalkohol-Polymer. Als hydrophile polymere Bindemittel (a1) der fotoempfindlichen Schicht (a) werden wasserlösliche Polyvinylalkohole und deren wasserentwickelbare Copolymere und Derivate genannt.

Kommerziell erhältlich sind bislang lediglich fotopolymerisierbare Flexodruckelemente auf einem doppelten Träger aus PET-Folie und einem Aluminiumblech (z.B. nylocoat^{®} LA 116 (BASF), Cyrel^{®} CLAM (Du Pont)). Bei diesen Platten ist die fotopolymere Schicht nicht direkt auf dem Aluminiumträger aufgebracht, sondern es handelt sich um übliche Flexodruckplatten auf PET-Trägerfolie, die beispielsweise mittels eines doppelseitigen Klebebandes auf einen zusätzlichen Aluminiumträger aufgeklebt sind. Dies erfordert einen zusätzlichen Arbeitsschritt, der sehr zeit- und personalintensiv ist. Zudem besteht beim Entwickeln der Platte die Gefahr, dass sich unter der Einwirkung des Auswaschmittels das Klebeband wieder vom Aluminiumträger löst. Die Verbundhaftung zwischen der PET-Folie und dem Aluminiumblech kann sich auch während des Druckprozesses aufgrund von mechanischer Beanspruchung lösen. Da sich durch den Haftungsverlust der Passer ändert, ist dieser Vorgang außerordentlich unerwünscht.

Die geschilderten Flexodruckplatten auf doppeltem PET/Aluminiumträger werden hauptsächlich zur Veredelung von Bogenoffsetdruck-Druckerzeugnissen, beispielsweise durch Lackierung oder Golddruck (siehe z.B. "Inline-Veredelung über Flexo-Lackierwerke", Deutscher Drucker 29 (1999) w2 - w6) eingesetzt. Für diesen Zweck vorgesehene Flexodruckplatten werden daher auch als Lackplatten bezeichnet. Auf diesem Gebiet wird besonderer Wert auf Passergenauigkeit gelegt. Moderne Flexo-Lackierwerke in Bogenoffset-Maschinen sind häufig mit Schnellspannschienen oder mit vollautomatischen Platteneinzugseinrichtungen ausgerüstet, die nur für den Einzug von Druckplatten mit einem Aluminiumträger geeignet sind. Flexodruckplatten auf doppeltem PET/Aluminiumträger werden von Kunden in Offset-Druckereien aufgrund ihrer deutlich höheren Dimensionsstabilität gegenüber den Flexodruckplatten auf Folienträger bevorzugt. Aluminium gibt gegenüber mechanischer Beanspruchung im Auflagendruck deutlich weniger nach als Polyester. Selbst bei Wiederholungsaufträgen mit mehrmaligem Ein- und Ausspannen ist die Dimensionsstabilität der Druckplatten auf Aluminiumträger gewährleistet.

Angesichts der vielen Vorteile von Flexodruckplatten auf metallischem Träger, wäre es wünschenswert, die elastomere, fotopolymerisierbare Schicht direkt auf den metallischen Träger aufzubringen, um das oben geschilderte, umständliche und aufwändige Herstellverfahren zu vermeiden.

In der Praxis sieht sich der Fachmann, der metallische Träger im Bereich Flexodruckplatten einsetzen will, jedoch einer Reihe von Problemen gegenüber.

Fotopolymerisierbare Flexodruckelemente werden üblicherweise durch Schmelzextrusion hergestellt. Die fotopolymere Masse wird durch eine Breitschlitzdüse zwischen eine Deckfolie und eine PET-Trägerfolie ausgetragen und der erhaltene Verbund kalandriert. Diese Technik kann jedoch nicht einfach auf metallische Trägerfolien übertragen werden. Abgesehen davon, dass es technisch sehr anspruchsvoll ist, einen metallischen Träger zum Kalandrieren einzusetzen, tritt vor allem das Problem der Wellenbildung auf. Bedingt durch die unterschiedlichen thermischen Ausdehnungskoeffizienten schrumpfen der Metallträger und die Deckfolie beim Abkühlen der schmelzextrudierten, fotopolymeren Masse unterschiedlich stark. Das unterschiedliche Schrumpfverhalten des metallischen Trägers und der Deckfolie führt zu einem Verzug im Flexodruckelement, das sich durch Wellenbildung äußert. Solche Flexodruckelemente können aufgrund der großen Dickentoleranzen nicht eingesetzt werden.

Der erste Schritt zur Herstellung von Flexodruckplatten aus fotopolymerisierbaren Flexodruckelementen ist üblicherweise die sogenannte Rückseitenbelichtung durch die transparente PET-Trägerfolie. Diese dient u.a. der Festlegung der Relieftiefe sowie der guten Versockelung der einzelnen Bildpunkte. Durch die Rückseitenbelichtung wird zunächst ein Teil der fotopolymerisierbaren Schicht vollständig polymerisiert, nämlich der untere Bereich, der an die Trägerfolie angrenzt. Der obere Teil der Schicht verbleibt zunächst unpolymerisiert. Aus dem oberen Teil wird erst in einem zweiten Verfahrensschritt durch bildmäßiges Belichten von der Oberseite her das eigentliche druckende Relief erzeugt. Die einzelnen Bildpunkte der Flexodruckplatte haften also nicht auf der Trägerfolie selbst, sondern befinden sich auf einer Schicht polymerisierten Materials, welches seinerseits vollflächig auf der Trägerfolie haftet. Das Verfahren der Rückseitenbelichtung ist beispielsweise dargestellt in "Technik des Flexodrucks", S. 148 ff., 4. Aufl., 1999, Coating Verlag, St. Gallen, Schweiz. Bei einer Flexodruckplatte auf metallischem Träger ist eine Rückseitenbelichtung naturgemäß nicht mehr möglich. Im Zuge der Entwicklung des Flexodruckelementes nach der Belichtung von der Oberseite her durch das Negativ wird folglich das nicht polymerisierte Material aus den unbelichteten Bereichen bis auf den Träger herab entfernt. Es besteht somit die Gefahr, dass insbesondere einzelne Bildpunkte mit nur kleiner Basisfläche und schwacher Haftung während der Entwicklung oder während des Druckvorganges vom Träger abgerissen werden.

Aufgabe der Erfindung war es daher, ein einfaches und wirtschaftliches Verfahren zur Herstellung organisch entwickelbarer Flexodruckplatten auf metallischen Trägern bereitzustellen.

Die Erfindung wird durch die Ansprüche definiert.

Zu dem erfindungsgemäßen Verfahren ist im Einzelnen das Folgende auszuführen.

Die eingesetzten metallischen Träger für die Flexodruckelemente sind flexibel. Unter flexibel im Sinne dieser Erfindung soll verstanden werden, dass die Träger so dünn sind, dass sie um Druckzylinder gebogen werden können. Sie sind andererseits aber auch dimensionsstabil und so dick, dass der Träger bei der Produktion des Flexodruckelementes oder der Montage der fertigen Druckplatte auf den Druckzylinder nicht geknickt wird.

Als flexible metallische Träger kommen vor allem dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht, wobei die Metalle auch noch legiert sein können. Es können auch kombinierte metallische Träger wie beispielsweise mit Zinn, Zink, Chrom, Aluminium, Nickel oder auch Kombinationen verschiedener Metalle beschichtete Stahlbleche eingesetzt werden, oder auch solche Metallträger, die durch Laminieren gleich- oder verschiedenartiger Metallbleche erhalten werden. Weiterhin können auch vorbehandelte Bleche, wie beispielsweise phosphatierte oder chromatisierte Stahlbleche oder eloxierte Aluminiumbleche eingesetzt werden. Im Regelfalle werden die Bleche oder Folien vor dem Einsetzen entfettet. Bevorzugt eingesetzt werden Träger aus Stahl oder Aluminium, besonders bevorzugt ist magnetisierbarer Federstahl.

Die Dicke derartiger flexibler metallischer Träger beträgt üblicherweise zwischen 0,025 mm und 0,4 mm, und richtet sich neben dem gewünschten Grad an Flexibilität auch nach der Art des eingesetzten Metalls. Träger aus Stahl haben üblicherweise eine Dicke zwischen 0,025 und 0,25 mm, insbesondere zwischen 0,14 und 0,24 mm. Träger aus Aluminium haben üblicherweise eine Dicke zwischen 0,25 und 0,4 mm.

Der flexible metallische Träger wird mit einer in Druckfarben und organischen Entwicklern unlöslichen und quellbeständigen, klebfreien Haftschicht versehen. Die Haftschicht vermittelt eine gute Haftung zwischen dem flexiblen, metallischen Träger und der später aufzubringenden fotopolymerisierbaren Schicht, so dass die durch bildmäßiges Belichten der fotopolymerisierbaren Schicht erhaltenen druckenden Elemente weder beim Entwickeln der Platte noch beim Drucken abreißen, abgelöst werden oder abknicken.

Die Oberfläche der Haftschicht ist klebfrei. Die Klebfreiheit läßt sich durch den Fachmann qualitativ durch Befühlen der Schicht ermitteln oder beispielsweise durch eine Pendelklebrigkeitsmessung quantitativ bestimmen. Weiterhin ist die Haftschicht in den üblichen organischen Entwicklern für Flexodruckelemente sowie üblichen organischen oder organische Komponenten enthaltenden Lösemitteln von Druckfarben unlöslich und quellbeständig. Typische organische Entwickler für Flexodruckelemente umfassen beispielsweise Carbonsäuerester, hydrierte Erölfraktionen bzw. Terpene im Gemisch mit Alkoholen. Beispielhaft sei auf die Veröffentlichungen EP-A 332 070, EP-A 463 486, EP-A 28 676, EP-A 433 374 oder WO 93/10484 verwiesen. Typische Lösemittel für Flexodruckfarben umfassen beispielsweise Alkohole wie Ethanol oder Isopropanol, ggf. im Gemisch mit Wasser.

In einer Ausführungsform des erfindungsgemäßen Verfahrens umfasst die Haftschicht ein Bindemittel, welches in eine geeignete polymere Matrix eingebettet ist. Im Regelfalle lassen sich unter dem Mikroskop diskrete Domänen von elastomerem Bindemittel und der Matrix erkennen.

Beispiele für geeignete Bindemittel für die Haftschicht umfassen elastomere oder thermoplastisch elastomere Polymere, die üblicherweise auch zur Herstellung von Reliefdruckplatten eingesetzt werden, wie Polymere oder Copolymere von 1,3-Dienen oder SIS- oder SBS-Blockcopolymere. Es können auch Gemische zweier oder mehrerer unterschiedlicher elastomerer Bindemittel eingesetzt werden.

Die Menge an elastomerem Bindemittel in der Haftschicht wird vom Fachmann je nach den gewünschten Eigenschaften bestimmt. Sie beträgt üblicherweise 10 bis 70 Gew.% bzgl. der Summe aller Komponenten der Haftschicht, insbesondere 10 bis 45 Gew. % und ganz besonders 15 bis 35 Gew. %.

Bei der polymeren Matrix handelt es sich üblicherweise um eine vernetzte polymere Matrix, die mittels eines geeigneten vernetzenden Systems erhältlich ist. Die vernetzte polymere Matrix kann thermisch durch Polykondensation oder Polyaddition geeigneter Monomerer bzw. Oligomerer erhalten werden, beispielsweise durch Reaktion von Polyisocyanaten und geeigneten hydroxylgruppenhaltigen Verbindungen wie hydroxygruppenhaltigen Polyurethanharzen oder Polyesterharzen unter Bildung von vernetzten Polyurethanen.

Weiterhin als geeignet hat sich eine Haftschicht auf Basis von modifizierten Polyvinylalkoholen erwiesen, die radikalisch vernetzbare Seitengruppen aufweisen. Diese Ausführungsform der Haftschicht umfasst einen teilverseiften Polyvinylalkohol, der mit Hilfe von Methacrylsäureanhydrid verestert wurde. Der Gehalt an radikalisch vernetzbaren Methacrylatgruppen liegt zwischen 1 und 10 Mol-%, vorzugsweise zwischen 3 und 5 Mol-%. Die Haftschicht umfasst weiterhin Bis-(N-Methylolacrylamid)-ethylenglycolether sowie einen Dialdehyd.

Optional können die Haftschichten weitere Komponenten und Hilfsstoffe wie beispielsweise zusätzliche Bindemittel zur Beeinflussung der Eigenschaften, Farbstoffe, Pigmente oder Weichmacher umfassen.

Als besonders vorteilhaft zur Ausführung der Erfindung hat es sich erwiesen, der Haftschicht einen migrationsstabilen-UV-Absorber zuzusetzen. Dadurch wird die Rückstreuung von UV-Licht durch den metallischen Träger im Zuge der bildmäßigen Belichtung des Flexodruckelementes unterbunden oder zumindest stark vermindert. Derartiges rückgestreutes Licht kann zu unerwünschter Polymerisation auch in solchen Bereichen der fotopolymerisierbaren Schicht führen, die eigentlich gar nicht polymerisiert werden sollen. Durch den Zusatz von migrationsstabilen UV-Absorbern zur Haftschicht wird vorteilhaft der Belichtungsspielraum der Flexodrukkelemente erhöht. Weiterhin werden die Sockel einzelner Bildpunkte schmaler, so dass die Tonwertzunahme der fertigen Flexodruckplatte beim Drucken geringer ist als ohne Zusatz eines derartigen UV-Absorbers. Als migrationsstabile UV-Absorber können vor allem solche UV-absorbierenden Substanzen eingesetzt werden, die ein hohes Molekulargewicht aufweisen und nur eine geringe Migrationstendenz aufweisen. Besonders vorteilhaft können UV-Absorber eingesetzt werden, die über reaktive Gruppen verfügen, so dass sie chemisch in die polymere Matrix eingebunden werden können. Als Beispiel sei ein mit Hydroxygruppen substituiertes Michler's Keton genannt, welches in eine Polyurethan-Matrix eingebunden werden kann.

Zur Herstellung der Haftschicht werden die Komponenten der Haftschicht üblicherweise in geeigneten Lösemitteln gelöst, intensiv miteinander gemischt, die Lösung gegebenenfalls filtriert und auf den flexiblen metallischen Träger aufgebracht. Das Aufbringen erfolgt bevorzugt mittels eines Gießers wobei die Dickeneinstellung durch die Einstellung der Breite des Gießspaltes erfolgt. Nach dem Aufbringen wird das Lösungsmittel abgedampft. Bei thermischen Systemen wird danach durch kurzes Erwärmen vernetzt. Bei fotochemischen Systemen wird nach dem Abdampfen des Lösemittels durch Bestrahlung mit UV-Licht vernetzt. Der Restlösemittelgehalt in der Schicht sollte unter 5 Gew. % bezüglich aller Bestandteile der Schicht betragen.

Die Dicke der Haftschicht beträgt üblicherweise 5 bis 100 µm, bevorzugt 10 bis 50 µm und besonders bevorzugt 15 bis 30 µm.

Es können auch mehrere Haftschichten gleicher, annähernd gleicher oder unterschiedlicher Zusammensetzung übereinander eingesetzt werden.

Ein weiterer Verfahrensschritt umfasst die Herstellung einer elastomeren, organisch entwickelbaren, fotopolymerisierbaren Schicht für das Flexodruckelement aus mindestens einem thermoplastisch elastomerem Bindemittel, einem oder mehreren ethylenisch ungesättigten Monomeren, mindestens einem Fotoinitiator oder Fotoinitiatorsystem sowie optional weiteren Bestandteilen wie beispielsweise Weichmacher, Inhibitoren für die thermisch initiierte Polymerisation, Farbstoffe, Pigmente, fotochrome Zusätze, Antioxidantien, weitere Bindemittel oder Extrusionshilfsmittel. Als thermoplastisch elastomere Bindemittel eignen sich insbesondere die üblichen Dreiblockcopolymere vom SIS- oder SBS-Typ. Derartige Zusammensetzungen zur Herstellung von organisch entwickelbaren, fotopolymerisierbaren Flexodruckelementen sind dem Fachmann prinzipiell bekannt und beispielsweise in DE-A 22 15 090, EP-A 084 851, EP-A 819 984 oder EP-A 553 662 offenbart. Unter den prinzipiell einsetzbaren Komponenten und Mengenverhältnissen der Komponenten trifft der Fachmann eine geeignete Auswahl je nach den gewünschten Eigenschaften des Flexodruckelementes bzw. der Flexodruckplatte.

Die Herstellung der fotopolymerisierbaren Schicht kann beispielsweise durch Gießen oder durch Schmelzextrudieren erfolgen. Die Dicke der fotopolymerisierbaren Schicht kann vom Fachmann je nach den gewünschten Eigenschaften der Druckform eingestellt werden. Für Flexodruckelemente auf flexiblen, metallischen Trägern bewährt hat sich eine Dicke zwischen 0,5 mm und 1,5 mm.

Bei der Herstellung durch Gießen werden alle Bestandteile der fotopolymerisierbaren Schicht in einem geeigneten Lösungsmittel klar gelöst, auf eine Deckfolie oder auf ein Deckelement aufgegossen, und anschließend wird das Lösungsmittel verdampft. Die Deckfolie dient im Zuge des Gießvorganges als Schichtträger für die fotopolymerisierbare Schicht und fungiert im späteren, fertig produzierten Flexodruckelement als Schutzfolie. Die Schutzfolie verhindert, dass das fotopolymerisierbare Flexodruckelement im Zuge von Lagerung oder Transport beschädigt wird, und muss vor dem bildmäßigen Belichten des Elements abgezogen werden. Der Restlösemittelgehalt der Schicht sollte möglichst niedrig sein, um Blasenbildung durch langsames Verdampfen von Restlösemittelanteilen zu vermeiden. Im Regelfalle sollte der Restlösemittelgehalt der fotopolymerisierbaren Schicht kleiner sein als 5 Gew. % bzgl. der Summe aller Bestandteile der Schicht. Bevorzugt ist der Restlösemittelgehalt kleiner als 3 Gew. %.

Als Deckfolie werden üblicherweise PET-Folien eingesetzt, die auch noch modifiziert sein können, bspw. durch Siliconisierung. Es können auch Deckelemente eingesetzt werden, die neben der Deckfolie noch weitere Schichten umfassen.

Ein Beispiel für eine weitere Schicht ist eine im Entwickler für die fotopolymerisierbare Schicht lösliche Deckschicht (auch als "release-layer" bekannt) zwischen der fotopolymerisierbaren Schicht und der Schutzfolie. Sie besteht häufig aus geeigneten Polyamiden und erleichtert das Abziehen der Schutzfolie vor dem Gebrauch des Flexodruckelementes, sowie das Auflegen des fotografischen Negativs zur Bebilderung.

Ein weiteres Beispiel ist eine vergleichsweise dünne, ebenfalls fotopolymerisierbare Oberschicht auf der fotopolymerisierbaren Schicht (auch als "top-layer" bekannt). Eine derartige Oberschicht ist beispielsweise in EP-A 084 851 offenbart. Dieser zweischichtige Aufbau hat den Vorteil, dass die Eigenschaften der Oberfläche der Druckform, wie beispielsweise Farbübertragung verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

Weiterhin sei eine IR-ablative Schicht genannt. Diese kann sich auf der fotopolymerisierbaren Schicht befinden oder auch - falls vorhanden - auf der Oberschicht. Derartige Schichten umfassen üblicherweise mindestens ein Bindemittel sowie Ruß. Sie dienen zur direkten, digitalen Bebilderung des fotopolymerisierbaren Flexodruckelementes mittels eines IR-Lasers. Beispiele für derartige Schichten finden sich in EP-A 767 407 oder in EP-A 654 150.

Die gegossene, elastomere, fotopolymerisierbare Schicht wird mit der von der Deckfolie oder dem Deckelement abgewandten Seite auf den mit der Haftschicht beschichteten, flexiblen metallischen Träger aufkaschiert. Als Kaschierlösungsmittel für die thermoplastisch elastomere Bindemittel enthaltende fotopolymerisierbare Schicht eignet sich insbesondere Toluol. Die Kaschierung kann aber auch ohne Lösungsmittel, beispielsweise mittels Heisskaschierung erfolgen. Dabei wird die elastomere, fotopolymerisierbare Schicht kurz vor dem Kalanderspalt entweder mittels eines Heissluftstromes oder aber mit Hilfe eines IR-Strahlers (z. B. Heraeus) auf eine Temperatur zwischen 50 und 100 °C, vorzugsweise zwischen 60 und 80 °C erwärmt. Durch die Lösungsmittelkaschierung ebenso wie durch die Heisskaschierung wird die Haftung zum metallischen Träger erhöht. In einer weiteren Ausführungsform des erfindungsgemäßen Verfahrens wird die fotopolymerisierbare Schicht in bekannter Art und Weise durch Schmelzextrudieren der oben geschilderten Zusammensetzung, Austragen durch eine Breitschlitzdüse zwischen eine Deckfolie oder ein Deckelement sowie eine temporäre Trägerfolie, gefolgt von Kalandrieren des Verbundes hergestellt.

Als temporäre Trägerfolie kann beispielsweise eine PET-Folie eingesetzt werden, die zur Erleichterung der späteren Abziehbarkeit auch noch modifiziert sein kann, beispielsweise durch Siliconisierung.

Zur weiteren Verarbeitung wird die temporäre Trägerfolie von der fotopolymerisierbaren Schicht abgezogen und danach in der oben geschilderten Art und Weise auf den mit der Haftschicht beschichteten, flexiblen metallischen Träger aufkaschiert.

Zur Herstellung der fotoempfindlichen Flexodruckelemente kann auch eine fotoempfindliche Schicht direkt auf den mit der Haftschicht beschichteten Träger aufgegossen werden, und die Deckfolie oder das Deckelement aufkaschiert werden.

Die nach dem erfindungsgemäßen Verfahren erhaltenen fotopolymerisierbaren Flexodruckelemente auf metallischem Träger weisen eine hervorragende Haftung der fotopolymerisierbaren Schicht auf dem metallischen Träger auf. Sie können in an sich bekannter Art und Weise zur Herstellung von Flexodruckformen eingesetzt werden. Einzig die bei Flexodruckelementen auf PET-Träger übliche Rückseitenbelichtung durch den Träger entfällt. Die Herstellung der Flexodruckformen kann dabei einmal in klassischer Arbeitsweise durch Abziehen der Schutzfolie, Auflegen eines fotografischen Negativs, bildmäßiges Belichten mit aktinischem Licht, Entwickeln, Trocknen und optional Nachbehandlung erfolgen. Alternativ kann die Herstellung über digitale Bebilderung erfolgen. Hierzu wird ein fotopolymerisierbares Flexodruckelement eingesetzt, das über eine IR-ablative Schicht verfügt. Die Herstellung der Flexodruckformen umfasst nun die Schritte Abziehen der Schutzfolie, bildmäßiges Beschreiben der IR-ablativen Schicht, bildmäßiges Belichten mit aktinischem Licht, Entwickeln, Trocknen und optional Nachbehandlung. Nähere Einzelheiten zu beiden Verfahren sind dem Fachmann bekannt und beispielsweise in EP-A 992 849 offenbart.

Die nach dem erfindungsgemäßen Verfahren eingesetzte Haftschicht vermittelt auch unter dem Einfluss der organischen Entwickler, in denen die Haftschicht weder quellbar noch löslich ist, eine hervorragende Haftung, so dass auch feine Bildpunkte fest auf dem Träger fixiert sind, obwohl die Reliefschicht in den unbelichteten Bereichen vollständig entfernt wird, und der Träger mit der Haftschicht freigelegt wird. In den freigelegten Bereichen sammelt sich während des Druckens nur wenig Staub an. Unterbrechungen des Druckprozesses zur Entfernung von Staub von der Druckplatte kommen seltener vor.

Die Klebfreiheit der erfindungsgemäß beschichteten metallischen Träger trägt weiterhin zu einer besonders wirtschaftlichen Produktion bei, denn die Träger können während der Produktion ohne zusätzliche Maßnahmen, wie beispielsweise dem Einlegen von Papier als Zwischenschicht, gestapelt oder gerollt werden, ohne dass sie zusammenzukleben.

Die folgenden Beispiele sollen die Erfindung näher erläutern, ohne dass dadurch der Umfang der Erfindung eingeschränkt wird.

### Beispiel 1:

### (a) Herstellung der Haftschicht

Es wurde eine Mischung aus einem SBS-Blockcopolymer (Kraton D-4150, 19,5 Gew.%), einem oligomeren PU-Harz mit OH-Gruppen (NPP 262, 35 Gew. %), einem Copolyester (Vitel 3300, 35 Gew. %), einem aromatischen Isocyanat (Desmodur L 67, 9,5 Gew. %) sowie einem UV-Absorber (Hydroxy-Michler's-Keton, 1 Gew. %) in THF durch intensives Mischen hergestellt, und auf Aluminiumträger (Dicke 0,3 mm) aufgegossen, das Lösungsmittel verdampft und durch Erwärmen auf 170 °C für 2,5 min vernetzt.

Es wurde eine Haftschicht mit einer Dicke von 12 bis 15 µm erhalten. Unter dem Mikroskop waren Kautschukpartikel von 80 bis 100 µm Durchmesser in einer kontinuierlichen Matrix zu erkennen. Die Haftschicht auf dem Träger war klebfrei. Die beschichteten Aluminiumbleche konnten aufeinander gestapelt werden, ohne dass sie zusammen klebten.

### (b) Herstellung der lichtempfindlichen Schicht

Es wurden folgende Komponenten eingesetzt:

| Komponente | Menge |
|---|---|
| | [Gew. %] |
| SBS-Kautschuk | 68 |
| Weichmacher | 23 |
| Monomer (Hexandioldiacrylat) | 7 |
| Fotoinitiator, Farbstoffe | 2 |

Die Komponenten wurden in Toluol gelöst, auf eine mit einer Entklebungsschicht versehene PET-Folie aufgegossen und bei 75 °C getrocknet. Der Restlösemittelgehalt der Schicht betrug 2 %.

### (c) Kaschieren

Die getrocknete, lichtempfindliche Schicht wurde auf das mit der Haftschicht versehene Aluminiumblech kaschiert. Kurz vor der Kaschierung wurde die getrocknete, lichtempfindliche Schicht mittels Heissluft auf eine Temperatur von ca. 60 °C erwärmt, ein Kaschierlösemittel wurde nicht verwendet.

### (d) Weitere Verarbeitung

### Herstellung des Druckklischees:

Nach einer Woche Lagerzeit wurden die Rohplatten zu Klischees verarbeitet. Folgende Verarbeitungsschritte wurden durchgeführt:
a. Abziehen der PET-Folie,
b. Auflegen eines Negativs,
c. Hauptbelichtung unter der Vakuumfolie (F III Belichter, BASF, 3-24 min in 3 min-Schritten),
d. Auswaschen der Platte (Durchlaufsystem Combi LF II, BASF, Durchlaufgeschwindigkeit 150 mm/min, organisches Auswaschmittel (auf Basis Kohlenwasserstofflösungsmitteln) nylosolv® II von BASF, 30 °C, Relief tiefe 1000µm),
e. 2 Stunden Trocknen bei 65 °C,
f. Nachbelichtung (UVA, F III Belichter, BASF, 15min),
g. Nachbehandeln mit UVC-Licht (F III Nachbehandlungsgerät, BASF, 15min).

Die Schritte a. bis g. entsprechen üblichen Verarbeitungsschritten für Flexodruckplatten auf transparenten PET-Trägern, nur wurde der Schritt der Rückseitenbelichtung ausgelassen. Das Testklischee wurde ausgewertet. Beurteilt wurde, bei welcher Belichtungszeit die Positiv-Testelemente (freistehender Punkt 100 µm, Gitter 100 µm und das 3%-Tonwert-Rasterfeld (24L/cm) auf dem Klischee korrekt ausgebildet waren. Der Zeitpunkt, zu dem alle Positivelemente korrekt ausgebildet sind, wird als Untere Belichtungsgrenze (UBG), d.h. die Mindestbelichtungsdauer für eine korrekte Abbildung, bezeichnet.

Darüber hinaus wurden auch die Negativelemente, d.h. der 500 µm-Negativpunkt und der 2000 µm-Graben beurteilt. Unterschreitet die Tiefe im Negativpunkt 70 µm bzw. im Graben 500 µm ist eine korrekte Farbübertragung nicht mehr gewährleistet. Der Zeitpunkt, zu dem mindestens eines der beiden Negativelemente diese Grenzen unterschreitet, wird als Obere Belichtungsgrenze (OBG), d.h. maximale Belichtungsdauer für ein brauchbares Klischee bezeichnet. Die Differenz von OBG-UBG ergibt den sog. Belichtungsspielraum (BSR), der für eine praxisgerechte Anwendung positiv sein muß. Der gemessene Belichtungsspielraum von + 10 min war positiv.

Weiterhin wurde die Haftung des Klischees auf dem Träger wie folgt bestimmt: Zur Bestimmung der Trägerschichthaftung wird zuerst ein Plattenstück im Format von ca. 10 x 20 cm zugeschnitten und für mindestens 20 Minuten vollflächig ohne Vakuumfolie durchbelichtet. Danach werden 2 Proben im Format 20 cm x 2 cm (± 0,1 cm) auf der Schlagschere zugeschnitten. Diese Streifen müssen einwandfrei geschnitten sein, da sonst Fehlmessungen entstehen können. Bevor die Prüfstreifen in die Zugprüfmaschine (Zwick) eingespannt werden können, muß man die Reliefschicht der Proben ca. 5 cm von Hand vom Träger abziehen. Die Zugprüfmaschine zieht die Reliefschicht im Winkel von 180° im Schälverfahren vom Träger ab und misst die dazu erforderliche Kraft in N/2 cm. Die Ergebnisse sind in Tabelle 1 zusammengefasst.

### Beispiel 2:

Es wurde wie in Beispiel 1 vorgegangen, nur wurde ein Träger aus Stahlblech (Dicke 0,14 mm) eingesetzt. Es wurde eine Haftschicht mit einer Dicke von 12 bis 15 µm erhalten. Unter dem Mikroskop waren Kautschukpartikel von 80 bis 100 µm Durchmesser in einer kontinuierlichen Matrix zu erkennen. Die Haftschicht auf dem Träger war klebfrei. Die beschichteten Stahlbleche konnten aufeinander gestapelt werden, ohne dass sie zusammen klebten. Das Haftungsniveau war im Vergleich zum Aluminiumblech geringer, aber immer noch genügend hoch, um eine ausreichende Haftung bei praxisüblicher Anwendung zu gewährleisten. Die Ergebnisse sind in Tabelle 1 zusammengefasst.

### Beispiel 3:

Es wurde wie in Beispiel 2 vorgegangen, nur wurde ein Haftlack aus Polyvinylalkohol, modifiziertem Polyvinylalkohol (ethylenisch polymerisierbare Seitengruppen), Glyoxal und Bis-(N-Methylolacrylamid)-ethylenglycolether eingesetzt. Der Haftlack wurde durch Erwärmen auf 180 °C für 2 Minuten vernetzt. Die Haftschicht auf dem Träger war klebfrei. Die beschichteten Stahlbleche konnten aufeinander gestapelt werden, ohne dass sie zusammen klebten. Das Haftungsniveau auf dem Stahlblech war hervorragend, die lichtempfindliche Schicht ließ sich nicht vom Träger trennen. Die Ergebnisse sind in Tabelle 1 zusammengefasst.

### Vergleichsbeispiel 4:

Es wurde ein für wässrig entwickelbare Hochdruckplatten vorgesehener Haftlack aus einem Polyamid und einem Phenolharz eingesetzt, wie in DE-A 22 02 357 beschrieben. Die Haftschicht auf dem Träger war klebfrei. Die beschichteten Stahlbleche konnten zwar aufeinander gestapelt werden, ohne dass sie zusammen klebten, die Haftung war mit nur 2,7 N/2 cm nicht ausreichend für die Anforderungen der Praxis. Die Ergebnisse sind in Tabelle 1 zusammengefasst.

### Vergleichsbeispiel 5:

Es wurde wie in Beispiel 1 vorgegangen, aber es wurde eine übliche Polyurethan-Haftschicht verwendet. Außerdem wurde vor der bildmäßigen Belichtung durch das fotografische Negativ (Schritte b. und c. der allgemeinen Vorschrift) noch eine Rückseitenbelichtung mit aktinischem Licht durch den PET-Träger hindurch durchgeführt. Die Haftung der Reliefschicht auf dem Träger war gut. Die Belichtungseigenschaften entsprachen denen der Platten auf metallischen Trägern. Dass beim erfindungsgemäßen Verfahren keine Rückseitenbeleuchtung erfolgen kann, hat also keine schlechteren Eigenschaften zur Folge.

Die Ergebnisse sind in Tabelle 1 zusammengefasst.

### Vergleichsbeispiel 6:

In Analogie zu Beispiel 1 wurde eine Mischung aus einem SBS-Blockcopolymer (Kraton D-KX222, 19,5 Gew.%), einem oligomeren PU-Harz mit OH-Gruppen (NPP 262, 35 Gew. %), einem aromatischen Isocyanat (Desmodur L 67, 9,5 Gew. %) sowie einem UV-Absorber (Hydroxy-Michler's-Keton, 1 Gew. %) hergestellt. Der Copolyester (Vitel 3300, 35 Gew. %) wurde durch ein spezielles Haftharz (Regalite 5100, Hercules) ersetzt. Die Mischung wurde in THF gelöst und auf einen Aluminiumträger (Dicke 0,3 mm) aufgegossen, das Lösungsmittel verdampft und durch Erwärmen auf 170 °C für 2,5 min vernetzt. Die Haftschicht war extrem klebrig, die Bleche konnten nach einem Stapeltest nicht wieder voneinander getrennt werden. Die Ergebnisse sind in Tabelle 1 zusammengefasst.

**Tabelle 1: Ergebnisse der Versuche und Vergleichsversuche.**

| | Beispiel 1 | Beispiel 2 | Beispiel 3 | Vergleichsbeispiel 4 | Vergleichsbeispiel 5 | Vergleichsbeispiel 6 |
|---|---|---|---|---|---|---|
| Träger | Aluminium | Stahl | Stahl | Stahl | PET-Folie | Aluminium |
| Haftlack | SBS/PU | SBS/PU | PVA | PA | PU | SBS/PU |
| Klebrigkeit | klebfrei | klebfrei | klebfrei | klebfrei | klebfrei | klebrig |
| Klischeehaftung [N/2 cm] | > 20 | 5,5 | > 20 | 2,7 | > 20 | 4,7 |
| Härte [°Shore A] | 75 | 73 | 75 | 75 | 75 | 74 |
| UBG [min] | 6 | 6 | 6 | - | 6 | - |
| OBG [min] | 16 | 16 | 16 | - | 16 | - |
| BSR [min] | 10 | 10 | 10 | - | 10 | - |
| Anmerkungen | | | | zu geringe Haftung | mit Rückseitenbelichtung | zu klebrig |

## Patentansprüche

1. Verfahren zur Herstellung von organisch entwickelbaren, fotopolymerisierbaren Flexodruckelementen auf flexiblen metallischen Trägern für die Herstellung von Flexodruckplatten mit den folgenden Schritten:
(a) Beschichten eines flexiblen, metallischen Trägers mit einer in Druckfarben und organischen Entwicklern unlöslichen und quellbeständigen, klebfreien Haftschicht, wobei die Haftschicht ein elastomeres Bindemittel umfasst, welches in eine polymere Matrix eingebettet ist, oder die Haftschicht modifizierte Polyvinylalkohole, welche vernetzbare Seitengruppen aufweisen, umfasst,
(b) Beschichten einer Deckfolie oder eines Deckelementes mit einer organisch entwickelbaren, elastomeren, fotopolymerisierbaren Schicht durch Lösen von mindestens einem thermoplastisch elastomeren Bindemittel, ethylenisch ungesättigten Monomeren, Fotoinitiator oder Fotoinitiatorsystem sowie optional weiteren Bestandteilen in einem geeigneten Lösemittel, Aufgießen der Lösung auf die Deckfolie oder das Deckelement gefolgt vom Verdampfen des Lösemittels,
(c) Kaschieren der elastomeren, fotopolymerisierbaren Schicht mit der von der Deckfolie abgewandten Seite auf den mit einer Haftschicht beschichteten, flexiblen metallischen Träger.

2. Verfahren zur Herstellung von organisch entwickelbaren, fotopolymerisierbaren Flexodruckelementen auf flexiblen metallischen Trägern für die Herstellung von Flexodruckplatten mit den folgenden Schritten:
(a) Beschichten eines flexiblen, metallischen Trägers mit einer in Druckfarben und organischen Entwicklern unlöslichen und quellbeständigen, klebfreien Haftschicht, wobei die Haftschicht ein elastomeres Bindemittel umfasst, welches in eine polymere Matrix eingebettet ist, oder die Haftschicht modifizierte Polyvinylalkohole, welche vernetzbare Seitengruppen aufweisen, umfasst,
(b) Schmelzextrudieren einer organisch, entwickelbaren, elastomeren, fotopolymerisierbaren Zusammensetzung, mindestens umfassend ein thermoplastisch elastomeres Bindemittel, ethylenisch ungesättigte Monomere, Fotoinitiator
oder Fotoinitiatorsystem sowie optional weitere Bestandteile,
oder Fotoinitiatorsystem sowie optional weitere Bestandteile, Austragen durch eine Breitschlitzdüse zwischen eine Deckfolie oder ein Deckelement sowie eine temporäre Trägerfolie, gefolgt von Kalandrieren des Verbundes,
(c) Abziehen der temporären Trägerfolie,
(d) Kaschieren der fotopolymerisierbaren Schicht mit der von der Deckfolie abgewandten Seite auf den mit der Haftschicht beschichteten, flexiblen metallischen Träger.

3. Verfahren nach Anspruch 1 oder 2, **dadurch gekennzeichnet, dass** es sich bei dem flexiblen, metallischen Träger um einen Träger aus Aluminium, Stahl oder magnetisierbaren Federstahl handelt.

4. Verfahren nach Anspruch 1 oder 2, **dadurch gekennzeichnet, dass** die fotopolymerisierbare Schicht eine Dicke zwischen 0,5 und 1,5 mm aufweist.

5. Verfahren nach einem der Ansprüche 1 bis 4, **dadurch gekennzeichnet, dass** das Deckelement eine Deckfolie und eine IR-ablative Schicht umfasst.

6. Verfahren nach einem der Ansprüche 1 bis 5, **dadurch gekennzeichnet, dass** die klebfreie Haftschicht einen migrationsstabilen UV-Absorber umfasst.

7. Organisch entwickelbares, fotopolymerisierbares Flexodruckelement umfassend einen flexiblen metallischen Träger und eine organisch entwickelbare elastomere fotopolymerisierbare Schicht aus mindestens einem thermoplastisch elastomeren Bindemittel, ethylenisch ungesättigten Monomeren, Fotoinitiator oder Fotoinitiatorsystem sowie optional weiteren Bestandteilen die durch eine Haftschicht miteinander verbunden sind, **dadurch gekennzeichnet, dass** die Haftschicht klebfrei und in Druckfarben und organischen Entwicklern unlöslich und quellbeständig ist, wobei die Haftschicht ein elastomeres Bindemittel umfasst, welches in eine polymere Matrix eingebettet ist, oder die Haftschicht modifizierte Polyvinylalkohole, welche vernetzbare Seitengruppen aufweisen, umfasst.

8. Flexodruckelement nach Anspruch 7, **dadurch gekennzeichnet, dass** die klebfreie Haftschicht einen migrationsstabilen UV-Absorber umfasst.

## Claims

1. A method for producing organically developable, photopolymerisable flexographic printing elements on flexible metallic supports for the production of flexographic printing plates comprising the following steps:
(a) coating a flexible, metallic support with a tack-free adhesion-promoting layer insoluble and swelling-resistant in printing inks and organic developers, wherein the adhesion-promoting layer comprises an elastomeric binder which is embedded in a polymeric matrix, or the adhesion-promoting layer comprises modified polyvinyl alcohols having crosslinkable side groups,
(b) coating a cover film or cover element with an organically developable, elastomeric, photopolymerisable layer by dissolving at least one thermoplastic elastomeric binder, ethylenically unsaturated monomer, photoinitiator or photoinitiator system optionally together with further constituents in a suitable solvent, pouring the solution onto the cover film or cover element followed by evaporation of the solvent,
(c) laminating the elastomeric, photopolymerisable layer with the side remote from the cover film onto the flexible metallic support coated with an adhesion-promoting layer.

2. A method for producing organically developable, photopolymerisable flexographic printing elements on flexible metallic supports for the production of flexographic printing plates comprising the following steps:
(a) coating a flexible, metallic support with a tack-free adhesion-promoting layer insoluble and swelling-resistant in printing inks and organic developers, wherein the adhesion-promoting layer comprises an elastomeric binder which is embedded in a polymeric matrix, or the adhesion-promoting layer comprises modified polyvinyl alcohols having crosslinkable side groups.
(b) melt extruding an organically developable, elastomeric, photopolymerisable composition at least comprising a thermoplastic elastomeric binder, ethylenically unsaturated monomer, photoinitiator or photoinitiator system optionally together with further constituents, outputting through a flat film die between a cover film or a cover element and a temporary support film, followed by calendering of the composite structure,
(c) peeling off the temporary support film,
(d) laminating the photopolymerisable layer with the side remote from the cover film onto the flexible metallic support coated with the adhesion-promoting layer.

3. A method according to claim 1 or claim 2, **characterised in that** the flexible, metallic support is a support made from aluminium, steel or magnetisable spring steel.

4. A method according to claim 1 or claim 2, **characterised in that** the photopolymerisable layer has a thickness of between 0.5 and 1.5 mm.

5. A method according to any one of claims 1 to 4, **characterised in that** the cover element comprises a cover film and an IR-ablative layer.

6. A method according to any one of claims 1 to 5, **characterised in that** the tack-free adhesion-promoting layer comprises a migration-resistant UV absorber.

7. An organically developable, photopolymerisable flexographic printing element comprising a flexible metallic support and an organically developable elastomeric photopolymerisable layer prepared from at least one thermoplastic elastomeric binder, ethylenically unsaturated monomer, photoinitiator or photoinitiator system optionally together with further constituents, which are joined to one another by an adhesion-promoting layer, **characterised in that** the adhesion-promoting layer is tack-free and insoluble and swelling-resistant in printing inks and organic developers, wherein the adhesion-promoting layer comprises an elastomeric binder which is embedded in a polymeric matrix, or the adhesion-promoting layer comprises modified polyvinyl alcohols having crosslinkable side groups.

8. A flexographic printing element according to claim 7, **characterised in that** the tack-free adhesion-promoting layer comprises a migration-resistant UV absorber.

## Revendications

1. Procédé pour produire des éléments flexographiques photopolymérisables à développement organique sur des supports métalliques souples pour la réalisation de plaques flexographiques, comprenant les étapes suivantes :
(a) revêtir un support métallique souple d'une couche d'accrochage exempte d'adhésif, résistante au gonflement et insoluble dans des encres d'impression et dans des révélateurs organiques, ladite couche d'accrochage comprenant un liant élastomère, lequel est noyé dans une matrice polymère, ou ladite couche d'accrochage comprenant des alcools polyvinyliques modifiés, lesquels comportent des groupes latéraux réticulables,
(b) revêtir une feuille de recouvrement ou un élément de recouvrement d'une couche photopolymérisable élastomère à développement organique, par dissolution d'au moins un liant élastomère thermoplastique, de monomères éthyléniquement insaturés, d'un photo-initiateur ou système photo-initiateur ainsi que, optionnellement, d'autres composants dans un solvant adapté, verser la solution sur la feuille de recouvrement ou l'élément de recouvrement, suivi de l'évaporation du solvant,
(c) appliquer la couche photopolymérisable élastomère, avec la face opposée à la feuille de recouvrement, sur le support métallique souple revêtu d'une couche d'accrochage.

2. Procédé pour produire des éléments flexographiques photopolymérisables à développement organique sur des supports métalliques souples pour la réalisation de plaques flexographiques, comprenant les étapes suivantes :
(a) revêtir un support métallique souple d'une couche d'accrochage exempte d'adhésif, résistante au gonflement et insoluble dans des encres d'impression et dans des révélateurs organiques, ladite couche d'accrochage comprenant un liant élastomère, lequel est noyé dans une matrice polymère, ou ladite couche d'accrochage comprenant des alcools polyvinyliques modifiés, lesquels comportent des groupes latéraux réticulables,
(b) extruder à l'état fondu une composition photopolymérisable élastomère à développement organique, comprenant au moins un liant élastomère thermoplastique, des monomères éthyléniquement insaturés, un photo-initiateur ou système photo-initiateur ainsi que, optionnellement, d'autres composants, extraire à travers une filière à fente large entre une feuille de recouvrement ou un élément de recouvrement et une feuille de support temporaire, suivi d'un calandrage du composite,
(c) retirer la feuille de support temporaire,
(d) appliquer la couche photopolymérisable, avec la face opposée à la feuille de recouvrement, sur le support métallique souple revêtu de la couche d'accrochage.

3. Procédé selon la revendication 1 ou 2, **caractérisé en ce que** le support métallique souple est un support en aluminium, en acier ou en acier à ressort magnétisable.

4. Procédé selon la revendication 1 ou 2, **caractérisé en ce que** la couche photopolymérisable présente une épaisseur comprise entre 0,5 et 1,5 mm.

5. Procédé selon l'une des revendications 1 à 4, **caractérisé en ce que** l'élément de recouvrement comprend une feuille de recouvrement et une couche ablative par IR.

6. Procédé selon l'une des revendications 1 à 5, **caractérisé en ce que** la couche d'accrochage exempte d'adhésif comprend un absorbeur UV stable à la migration.

7. Élément flexographique photopolymérisable à développement organique comprenant un support métallique souple et une couche photopolymérisable élastomère à développement organique constituée d'au moins un liant élastomère thermoplastique, de monomères éthyléniquement insaturés, d'un photo-initiateur ou système photo-initiateur ainsi que, optionnellement, d'autres composants, qui sont assemblés l'un à l'autre par une couche d'accrochage, **caractérisé en ce que** la couche d'accrochage est exempte d'adhésif, résistante au gonflement et insoluble dans des encres d'impression et dans des révélateurs organiques, ladite couche d'accrochage comprenant un liant élastomère, lequel est noyé dans une matrice polymère, ou ladite couche d'accrochage comprenant des alcools polyvinyliques modifiés, lesquels comportent des groupes latéraux réticulables.

8. Élément flexographique selon la revendication 7, **caractérisé en ce que** la couche d'accrochage exempte d'adhésif comprend un absorbeur UV stable à la migration.
